# EUROPEAN PATENT SPECIFICATION

(11) **EP 3 800 508 B1**
(45) Date of publication and mention of the grant of the patent: **04.05.2022**
(21) Application number: 20209977.6
(22) Date of filing: 26.10.2016
(51) Int. Cl.: G03F 7/20

(54) **SYSTEM AND METHOD FOR CONTROLLED EXPOSURE OF FLEXOGRAPHIC PRINTING PLATES**
SYSTEM UND VERFAHREN ZUR GESTEUERTEN BELICHTUNG VON FLEXODRUCKPLATTEN
SYSTÈME ET PROCÉDÉ D'EXPOSITION CONTRÔLÉ DE PLAQUES D'IMPRESSION FLEXOGRAPHIQUE

(30) Priority: 26.10.2015 US 201562246276 P
(43) Date of publication of application: 07.04.2021
(62) Divisional of application: 16816384.8
(73) Proprietor: Esko-Graphics Imaging GmbH, 25524 Itzehoe (DE)
(72) Inventor: WOLTERINK, Jorg, 25524 Oelixdorf (DE); HANSEL, Thomas, 01309 Dresden (DE); SIEVERS, Wolfgang, 25569 Kremperheide (DE)
(74) Representative: Müller-Boré & Partner Patentanwälte PartG mbB

(56) References cited:
- WO-A1-2015/044437
- US-A- 5 386 268
- US-A1- 2013 209 939

## Description

### BACKGROUND OF THE INVENTION

Many processes are known in the art for preparing polymer printing plates, such as photopolymer flexographic plates and letterpress printing plates coated with photopolymer material. One known process starts with a plate having an ablatable material thereon, imaging the plate in a digital imager to ablate the ablatable material according to imaging data, and then curing the exposed plate by exposure of the plate to radiation, such as light energy, including but not limited to ultraviolet (UV) light energy.

Various processes for curing the plate on both the imaged side and the back side of the plate by exposure to a functional energy source are known, including methods for providing a blanket exposure (such as with fluorescent light tubes that emit UV light), and methods for providing the desired radiation using light emitting diode (LED) technology, such as is described in U.S. Patent No. 8,389,203. One particularly useful LED arrangement is shown and described in U.S. Pat. No. 8,578,854.

Known processes include exposing the back of a plate, then performing laser ablation on the front side of the plate, then performing front side exposure. Other processes include laser ablating the front side of the plate, then curing one side of the plate using a blanket exposure, manually flipping the plate, and then curing the other side of the plate. Each of the foregoing processes interposes an undefined, variable time delay between the first and second exposure, depending upon the amount of time for the laser ablation step in the first process, or depending upon the time it takes to manually flip the plate, in the second. This variability in elapsed time between first and second exposure leads to undesirable variability in plate quality. Still other processes may include exposing both the back side and the front side of a plate simultaneously, which although it produces more predictable results than a process that imposes a variable time delay, is still not optimal, as discussed more herein later.

In the field of printing, minimizing the size of a dot printed on a substrate is desirable, but smaller dots correspond to smaller printing plate elements, which are more susceptible to damage during use. Accordingly, there is always a need in the art to reduce the size or printed dots, while also providing optimal stability of the printing elements on the plate for making those printed dots.

WO 2015/044437 A1 relates to a device for automatically carrying out a rear-face pre-exposure process and a main exposure process and for developing flexographic printing elements which can be digitally imaged and to a method for producing flexographic printing plates on the basis of digitally imaged flexographic printing elements using said device.

Thus, according to an aspect, the problem relates to how to optimize the printing details of a printing plate.

This problem is solved by the subject-matter of the independent claims. Preferred embodiments are defined in the dependent claims.

### BRIEF DESCRIPTION OF DRAWINGS

FIG. 1 is a schematic drawing depicting an exemplary apparatus for the back exposure of a photosensitive printing plate in accordance with aspects of the invention.
FIG. 2A depicts a "single element number 64" as referred to herein, comprising 8 by 8 single pixels.
FIG. 2B depicts a "single element number 144" as referred to herein, comprising 12 by 12 single pixels.
FIG. 3A is a photograph of a 3D perspective side view of an exemplary printing plate element.
FIG. 3B is a photograph of a top view of the exemplary printing plate element of FIG. 3A.
FIG. 3C is a photograph of a top view of a dot printed on a substrate by the printing plate element of FIG. 3A.
FIG. 4 is a table showing and depicting with photographs resulting dot diameters corresponding to 64-pixel and 144-pixel single element structures exposed at various time delays from 0 to 1500 seconds. Numbers in this table use a comma as the decimal mark symbol to separate the integer portion from the fractional portion of non-whole numbers.
FIG. 5 is a graph corresponding to the results of FIG. 4, illustrating the dot ground diameter for the smallest processed single dot element on a printing plate versus time delay between back exposure and main exposure for an exemplary set of processing conditions.
FIG. 6 is a graph corresponding to the results of FIG. 4, illustrating the smallest printed dot diameter versus time delay between back exposure and main exposure for an exemplary set of processing conditions.
FIG. 7 is a schematic drawing depicting an apparatus having a cylindrical configuration for the back exposure of a photosensitive printing plate in accordance with aspects of the invention.
FIG. 8 is a schematic drawing depicting an apparatus featuring a planar radiation source for the back exposure of a photosensitive printing plate in accordance with aspects of the invention.
FIG. 9 is a schematic drawing depicting an apparatus featuring a single linear radiation source for the back exposure of a photosensitive printing plate in accordance with aspects of the invention.
FIG. 10 is a flowchart depicting an exemplary method of the invention. FIG. 11 is a schematic illustration depicting a flatbed embodiment of the invention.
FIG. 12 is a schematic illustration of a light source embodiment comprising a plurality of units having a plurality of rows of point sources.
FIG. 13 is a schematic drawing depicting a portion of the plate during exposure.

### SUMMARY OF THE INVENTION

One aspect of the invention comprises an apparatus for exposing a printing plate, the printing plate comprising a photosensitive polymer activated by exposure to radiation, the printing plate having a non-printing back side and a printing front side with a mask for defining an image to be printed. The apparatus comprises one or more radiation sources collectively arranged to expose the front side and the back side of the printing plate to radiation, a holder configured to receive the printing plate in a position to receive incident radiation from the one or more radiation sources, and a controller connected to the one or more radiation sources. The apparatus is configured to, for each specific coordinate corresponding to a cross-sectional portion of the plate, first commence irradiating the back side of the plate, then automatically impose a precisely defined and repeatable time delay, and then immediately after the time delay elapses, commence irradiating the front side of the plate, all without exposing any specific coordinate to front side and back side irradiation simultaneously.

Some embodiments comprise at least one front source and at least one back source of radiation, wherein the at least one front source is positioned to expose the front side of the plate, and the at least one back source is positioned to expose the back side of the plate. In some embodiments, each of the at least one front source and the at least one back source have an irradiation field covering an area at least coextensive with a width of the plate but not coextensive with a full length of the plate, wherein the front and back source are spaced apart from one another by a lateral distance along the length of the plate. Such embodiments further comprise means for causing relative movement between the printing plate and the front and back sources, wherein the relative movement has a velocity sufficient to cause the defined time delay over the lateral distance. In such embodiments, a trailing edge of the back source may be spaced apart by a lateral distance along the length of the plate from a leading edge of the main source. In embodiments in which the printing plate is fixed, the means for causing relative movement comprises means for moving the front and back radiation sources relative to the substrate. In embodiments in which the front and back radiation sources are fixed, the means for causing relative movement comprises means for moving the substrate relative to the sources of radiation. In some embodiments, the substrate is cylindrical and the velocity is a rotational velocity of the cylinder.

In other embodiments, the plate, the at least one front source, and the at least one back source are all stationary, and the controller is configured to implement the time delay by imposing a time difference between activating the at least one back source and activating the at least one front source, including in an embodiment in which each of the at least one front source and the at least one back source each are configured to emit a radiation field covering an area at least coextensive with both a length and width of the plate. Still another embodiment comprises a single source of radiation and means for traversing the single source around a stationary printing plate.

Another aspect of the invention comprises a process for exposing a printing plate comprising a photosensitive polymer activated by exposure to radiation, the printing plate having a non-printing back side and a printing front side with a mask for defining an image to be printed. The process comprises the sequential steps of (a) commencing irradiating the back side of the printing plate; (b) automatically imposing a precisely defined and repeatable time delay; and (c) immediately after the time delay elapses, commencing irradiating the front side of the printing plate, without exposing any specific coordinate to both front side and back side irradiation simultaneously. In an embodiment in which each radiation step is only a fraction of a total amount of desired radiation, the method comprises repeating steps (a) through (c) until the plate has been exposed to a desired amount of total radiation.

In a process for optimizing the time delay for a specific type of printing plate at a specific set of exposure conditions, the method comprising performing steps (a) through (c) for a plurality of samples of a specific type of plate for a specific set of exposure conditions for a plurality of different defined time delays, creating a plurality of prints, each print corresponding to one of the plurality of samples; and selecting as an optimum the time delay corresponding to the print having the smallest stable print dots. An exemplary method for identifying the optimum time delay may comprise performing several exposure samples at different time delays, with an identical number of exposure repetitions, back and front irradiation, then printing all of the samples and selecting the time delay corresponding to the print which holds the smallest print dots. In some instances, the step of adjusting the delay time may comprise selecting a time delay corresponding to a minimum value for the smallest printed minimum dot diameter that coincides with a maximum value for the dot ground diameter for a range of time delay values.

The process may be performed using any of the apparatus described herein. Thus, in a process performed using an apparatus having at least one stationary front source positioned to irradiate the front side of the plate, at least one stationary back source positioned to irradiate the back side of the plate, and a stationary plate, the method comprises implementing the time delay by imposing a time difference between activating the back source and activating the front source. In a method performed using an apparatus comprising at least one front source positioned to irradiate the front side of the plate, at least one back source positioned to irradiate the back side of the plate, each of the at least one front source and the at least one back source having an irradiation field covering an area at least coextensive with a width of the plate but not coextensive with a full length of the plate, and the at least one front source and the at least one back source spaced apart from one another by a lateral distance along the length of the plate, the method further comprises the step of causing relative movement between the printing plate and the at least one front and at least one back sources, wherein the relative movement has a velocity sufficient to cause the defined time delay over the lateral distance.

In an embodiment in which the printing plate is stationary, the step of causing relative movement comprises moving the at least one front source and the at least one back source relative to the substrate. In an embodiment in which the at least one front source and the at least one front back source are stationary, the step of causing relative movement comprises moving the substrate relative to the radiation sources.

Yet another aspect of the invention comprises a printing plate prepared by any of the methods or using any of the apparatus described herein, in which the printing plate has stable print dots smaller than a plate prepared using a method that does not include the defined time delay between commencement of back side and front side irradiation. The delay time may be optimized such that the curing result after complete processing of the printing plate yields smaller and more stable dots from the printing of the plate as compared to a plate exposed without such a time delay or compared to a plate exposed with a very long time delay.

### DETAILED DESCRIPTION OF THE INVENTION

Those of skill in the art understand that oxygen is distributed throughout the photopolymer resin of a polymer plate at the time it is typically processed, and that oxygen is an inhibitor of the polymerization reaction commonly harnessed for curing the plates. Although polymerization caused by exposure of the polymer to actinic radiation scavenges this distributed oxygen, ambient oxygen will diffuse back into the resin over time if the plate is in contact with atmospheric air. Surprisingly, in processes in which a back exposure and main exposure are both performed on a plate, it has been found that fine detail on a plate may be optimized by imparting a defined delay between performing the back exposure and the main exposure. Without being held to any particular mechanism, it is believed that in this defined delay time following the back exposure, which scavenges oxygen from the back portion of the plate, oxygen from the front side of the plate starts to diffuse to the back side, thus creating a slightly less oxygen rich concentration in the area of the plate nearest the floor of the plate, such that the polymerization reactions near the floor of the plate react for longer before stopping and therefore create shapes on the plate that taper from the floor toward the top of the plate following the main exposure. It should be noted that a delay that is too long will reset the entire plate to being oxygen saturated, and a delay that is too short may not permit sufficient oxygen diffusion to produce optimal results. Thus, while the amount of the optimal delay may vary depending on any number of characteristics, what is important is that the delay not be too long or too short, for optimal results. This delay may be imparted in any number of ways, described in more detail herein.

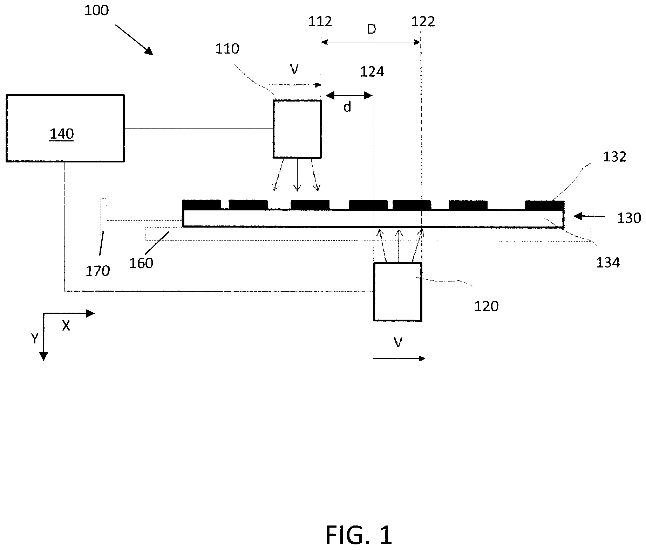

An exemplary apparatus 100 for the back exposure of photosensitive printing plate 130 is shown schematically in FIG. 1. As is well known in the art, printing plate 130 comprises a photosensitive polymer 134 on which is disposed a mask 132 that defines portions of the plate that are masked from radiation exposure relative to portions of the plate that are desired to receive such exposure. In a typical embodiment, the polymer 134, including in the mask 132 area, is permeable to oxygen.

In apparatus 100, a UV source of actinic radiation 120 with a predetermined power density is scanned at a specific speed (v) under the bottom of the plate. For the main or front exposure of the photosensitive printing plate a second UV source of radiation 110 with a predetermined power density (irradiance) is scanned above the plate with the same specific speed (v). UV sources of radiation 110 and 120 are configured to scan the printing plate with the same speed (v). Such a configuration may be provided by synchronizing sources 110 and 120 to have a same speed using a controller, or both sources may be attached to a common carriage that traverses the plate, with sources 110 and 120 spaced apart from one another a suitable distance in the direction of carriage travel to provide the desired delay when the carriage moves at a predetermined speed. The predetermined irradiance may be the same for the main side and the back side, or may be different. Preferably the irradiance at the rear side is only a fraction of the irradiance of the front side exposure. Typically, the irradiance at the rear side is in a range of 10% or less of the front side irradiance, but the invention is not limited to any particular ratio of front to back irradiance. The predetermined irradiance is typically a function of the characteristics of the specific type of plate to be exposed, as is known to those of skill in the art, and as is dictated by the manufacturers of such plates.

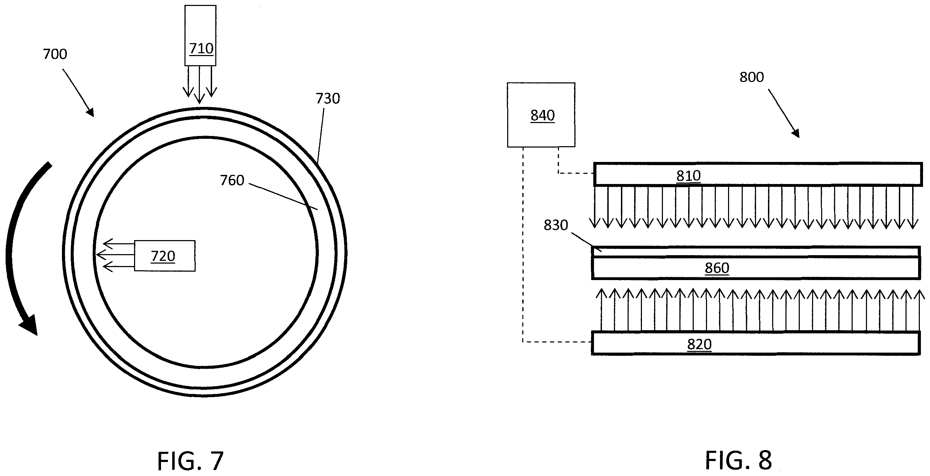

The time delay between the back exposure with UV source of radiation 120 and the main exposure with UV source of radiation 110 may be adjusted by the control system 140 by adjusting the speed of the sources and/or mechanically by setting a constant distance (D) between the sources during the scan process. The time delay t =D/v. Thus, mechanically varying D has an impact on the delay, as does the relative speed between the plate and the sources during exposure. The time delay can be optimized to get smaller single dot elements on the photosensitive printing plate after processing and smaller single element dot sizes printed on the print substrate. It should be understood that the arrangement depicted in Fig. 1 is schematic in nature only, to show the relationship between the light sources and the distance D relative to a plate. In a system 100 in which printing plate 130 is disposed along a horizontal plane (i.e. in which directional arrow Y of the X-Y axis shown in FIG. 1 represents the directional pull of gravity), plate 130 may be mounted on a transparent substrate 160 (such as glass). In a system 100 in which printing plate 130 is disposed along a vertical plane (i.e. a system in which directional arrow X of the X-Y axis represents the directional pull of gravity), the plate may be hung vertically (such that no substrate under the plate or other structure between the radiation source and the plate are required), such as from a hanger 170. It should be understood that hangar 170 as depicted in FIG. 1 is intended only to be schematic, and is not intended to represent any particular hangar geometry. Furthermore, although shown in a flat orientation, it should be understood that the printing plate may be flexible enough to be disposed around a transparent cylinder, such as a glass cylinder, or the plate may be in the form of a continuous sleeve, as is known in the art, with the distances between the light sources arranged relative to the rotational direction of the cylinder, as generally depicted in Fig. 7 and described in more detail herein later.

The relative movement between the radiation sources and the plate may be provided by any mechanism known in the art for moving objects relative to a horizontal, vertical, or otherwise disposed stationary surface. For configurations in which the radiation sources move and the plate is stationary, for example, the sources may be disposed on a gantry system having arms that pass the respective sources above and beneath a stationary horizontal plate mounted on a substrate configured to permit a sufficient amount of radiation to pass through, or on either side of a vertically mounted plate. For configurations in which the radiation sources are stationary and the plate is movable, for example, the plate may be mounted on any mechanism known in the art, such as a movable stage configured to move relative to fixed sources on opposite sides of the stage. Mechanisms for rotating a cylinder on which a plate is mounted relative to fixed sources are well known in the field of printing. Similarly, mechanisms for rotating sources relative to a fixed cylinder on which a stationary object is mounted are also well known, such as in the field of medicine (e.g. CAT scan machines). Thus, mechanisms for moving one or more elements relative to another are well known in the art, generally, and the invention is not limited to any particular mechanism.

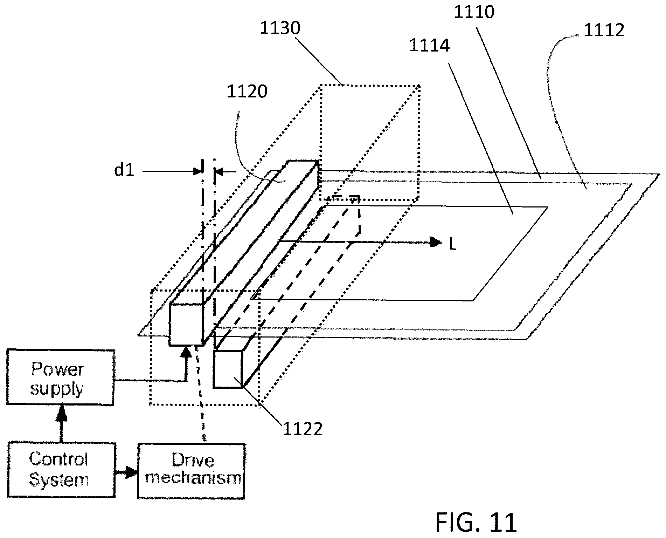

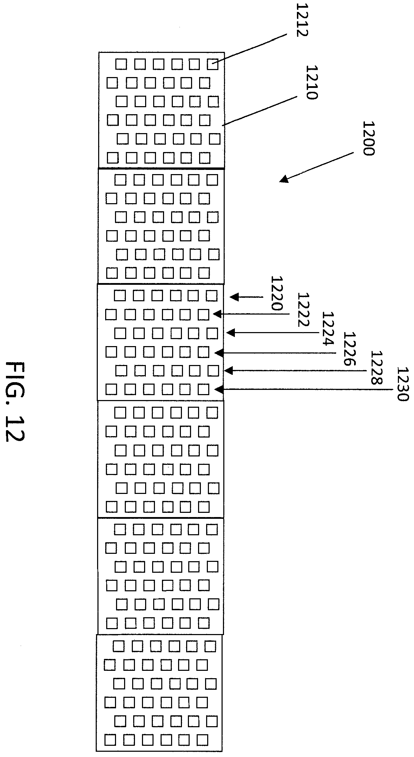

As shown in Fig. 1, it should be understood that each of the front source 110 the back source 120 have an irradiation field covering an area at least coextensive with a width of the plate (wherein the "width" lies along the third dimension not shown in the 2-dimensional image of FIG. 1) but not coextensive with a full length of the plate (wherein the "length" lies along the X-axis as shown in Fig. 1). Each of the front source and the back source may thus comprise a linear source (such as sources 1120 and 1120 shown in FIG. 11) that emits radiation along a line parallel to the width of the plate. Each linear source, however, may comprise a plurality of subsources (such as LED point sources 1112 shown in FIG. 12) that together collectively create the linear radiation field having a defined length less than the length of the printing plate, and a width that spans at least the entire width of the printing plate.

In one embodiment, shown in Fig. 11, carriage 1130 may comprise a first linear source 1122 arranged to irradiate the back side of a plate 1114 mounted on transparent surface 1112, such as a glass plate, and a second linear source 1120 arranged to irradiate the top side of the plate. Each linear source extends to cover one dimension of the plate, which in the example shown shall be referred to as the transverse direction. The carriage traverses the plate in the longitudinal (or lateral) direction along arrow L, with at least one source, and preferably both sources, activated. While the exposure step may be performed in a single pass, in some embodiments the exposure may be performed in a plurality of passes, in which each pass imparts radiation using both banks of sources at a fraction of the total exposure needed to provide a desired amount of exposure. As will be understood, the carriage may have a first speed when traversing the plate along the direction of arrow L with radiation sources activated, and a second, faster speed when traversing the plate in the direction opposite arrow L, to reset for another pass or at the completion of the desired number of passes.

The overall mechanism for creating the exposure may comprise a table having an outer frame 1110 that holds a transparent (e.g. glass) inner portion 1112. The upper 1120 and lower 1122 linear radiation sources (e.g. banks of LED point sources, optionally mounted inside a reflective housing) are mounted on a gantry system or carriage 1130. The radiation sources are connected to a power source, such as an electrical power cord having sufficient slack to extend the full range of motion of the carriage. Tracks (not shown) disposed on the outer frame portion provide a defined path for the gantry system or carriage to traverse. The carriage may be moved on the tracks by any drive mechanism known in the art (also coupled to the power supply and the controller), including a chain drive, a spindle drive, gear drive, or the like. The drive mechanism for the carriage may comprise one or more components mounted within the carriage, one or more components fixed to the table, or a combination thereof. A position sensor (not shown) is preferably coupled to the carriage to provide feedback to the controller regarding the precise location of the carriage at any given time. The control signal output from the controller for operating the radiation sources and for controlling motion of the carriage may be supplied via a wired or wireless connection. The controller may be mounted in a fixed location, such as connected to the table with a control signal cable attached to the sources similar to the power cable, or may be mounted in or on the carriage. The control system and drive mechanism cooperate to cause back/forth relative motion in a transverse direction between the light from the radiation sources and the plate. If should be understood that other embodiments may be devised in which the drive mechanism is configured to move the portion of the table containing the plate past stationary upper and lower linear radiation sources, as well as embodiments in which the radiation sources cover less than the full width of the plate and are movable in both the transverse and longitudinal direction to provide total plate coverage (or the plate is movable in both directions, or the plate is movable in one of the two directions and the sources are movable in the other direction to provides the full range of motion required to cover the entire plate).

In one work flow configuration, the table for conducting the exposure step (i.e. exposure table) as described above may be positioned to automatically receive an imaged plate from an imager. For example, an imager may be positioned so that the imaged plate expelled therefrom lands in a first location, and a robotic handling device may be configured to automatically pick up and move the imaged plate from the first location to a processing location on the exposure table, where the exposure process as described herein is then performed using transverse linear sources attached to a carriage that traverses the plate longitudinally.

As discussed in U.S. Pat. No. 8,578,854 and illustrated schematically in FIG. 12, each bank 1200 of LED sources may comprise a plurality of discrete units 1210 having a plurality of individual LED point sources 1212 on each unit, with the plurality of point sources arranged in a plurality of lines 1220, 1222, 1224, 1226, 1228, 1230. All of the point sources on each unit may be controlled together, may be individually controlled, or may be controlled in groups. For example, each line of point sources in each unit (e.g. each of lines 1220, 1222, 1224, 1226, 1228, 1230) may be separately controllable. Providing such a fine level of control may have several advantages. For example, the actual output from each line of LEDs may vary slightly for the same amount of input energy, due to variations in the LEDs themselves, soldering to the circuit board, cooling, decay or wear over time, and the like, and thus, each line of LEDs may be characterized and their intensity varied by an appropriate factor relative to other lines to so that the radiation output produced by each line is as close to homogenous as possible. Characterizations and re-calibration may be performed on a periodic basis to account for variations in the lines over time. Such characterizations may be performed by positioning a sensor that measures incident radiation at a predetermined distance from each line of LED sources. On top of compensation for variations in the output intensity of the LEDs themselves, further compensations may be made for variations in transmissivity of any structure that lies between the sources and the printing plate, such as for example, the glass surface 1112 that lies between the back sources and the printing plate in the configuration shown in Fig. 11. Any characterizable variations in transmissivity of emitted radiation through the glass surface can be countered by varying the intensity of the LEDs based upon carriage location so that the amount of radiation that reaches the back of the plate is as close to homogenous as possible over the entire exposed plate area.

### DEFINITIONS

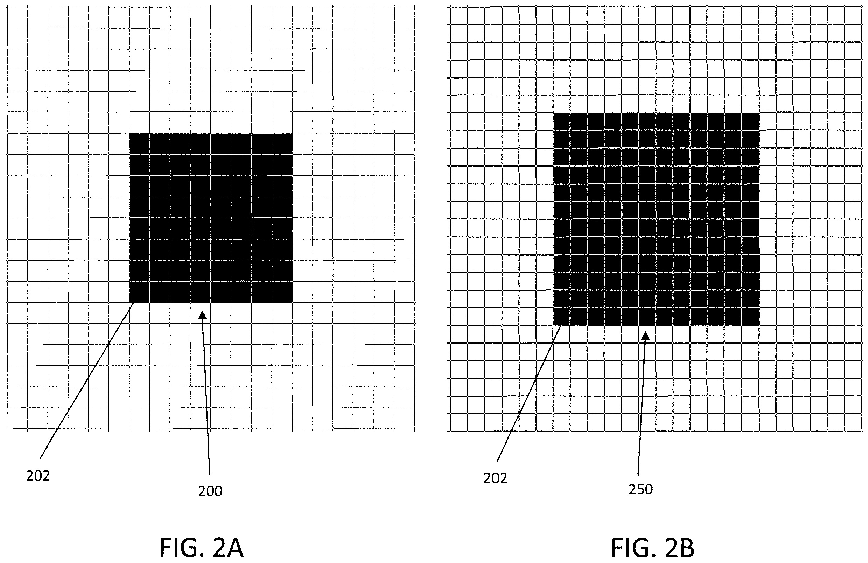

The term "single element structure number" as used herein refers to a square defined by the total number of pixels that comprises that square. For example, a "64-pixel single element structure" comprises square 200, which comprises an 8x8 grid of pixels 202, and has a total of 64 pixels, as illustrated in FIG. 2A. Likewise "144-pixel single element structure" 250 comprises a grid of 12x12 pixels 202, yielding a total of 144 pixels, as illustrated in FIG. 2B.

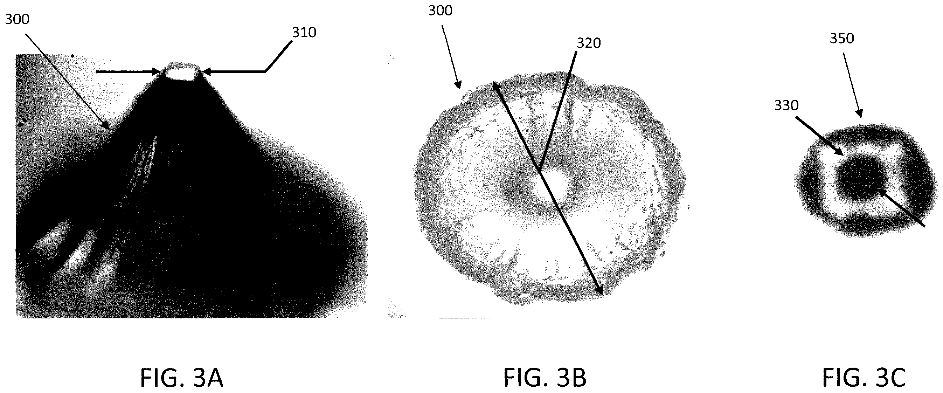

The term "dot top diameter" refers to the diameter of the top of a printing plate element or "dot" (i.e. the portion of the element that contacts the printing surface), as illustrated in FIG. 3A, showing a photograph of a 3-dimensional perspective side view of an exemplary printing plate element 300 and its dot top diameter 310. The term "dot ground diameter" refers to the diameter at the base of a printing plate element or "dot" (i.e. the diameter of the element at the floor or "ground" of the plate), as illustrated in FIG. 3B, which is a photograph of a top view of exemplary printing plate element 300 and its dot ground diameter 320. The term "printed dot diameter" refers to the diameter of the dot that is printed on a substrate by a printing element, as illustrated in FIG. 3C, which is a photograph of a top view of printed dot 350 and its printed dot diameter 330.

### EXAMPLE

For optimization of the time delay, single element structures of various sizes were imaged by a laser into the mask of a photosensitive printing plate at a resolution of 4000 dpi. For this example, a Model No. DPR 045 printing plate, manufactured by DuPont, was used.

The photosensitive printing plates were then back exposed, such as by using UV radiation source 120, and main exposed, such as by using UV radiation source 110, as depicted in FIG. 1. For this example, each source 120 and 110 source comprised a linear source comprising a bank of individual LED UV point sources, as described in more detail herein. The plate was exposed in a single exposure step using a main side UV irradiance of 230 mw/cm² at a wavelength of 360 nm and a back side UV irradiance of 17 mw/cm² at the same wavelength at a relative plate speed of 1.25 mm/sec. For this example, the UV radiation sources were moved lengthwise under and above the surface of each photosensitive printing plate at the specified speed. The time delay was varied to optimize the smallest single dot element on the processed photosensitive printing plate and printed to optimize the smallest printable dot size on the printing substrate.

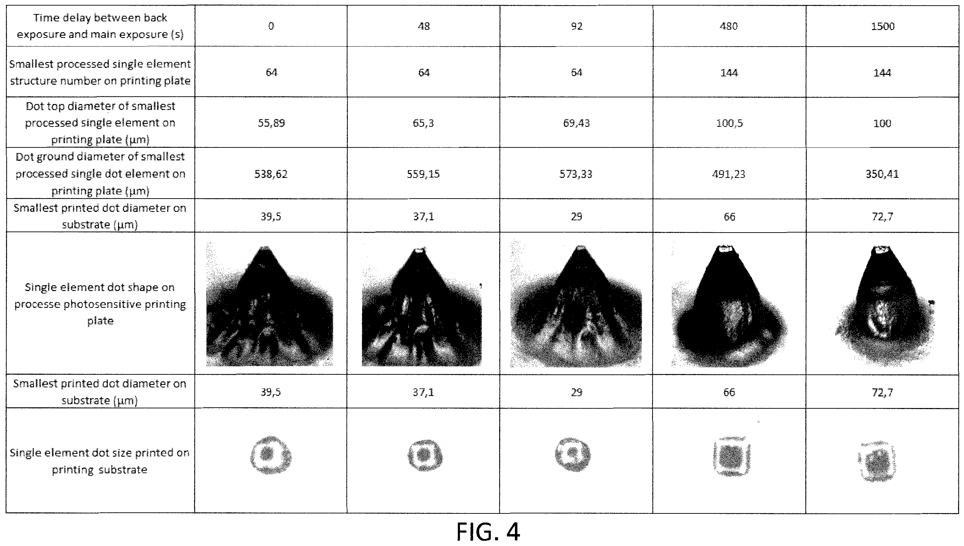

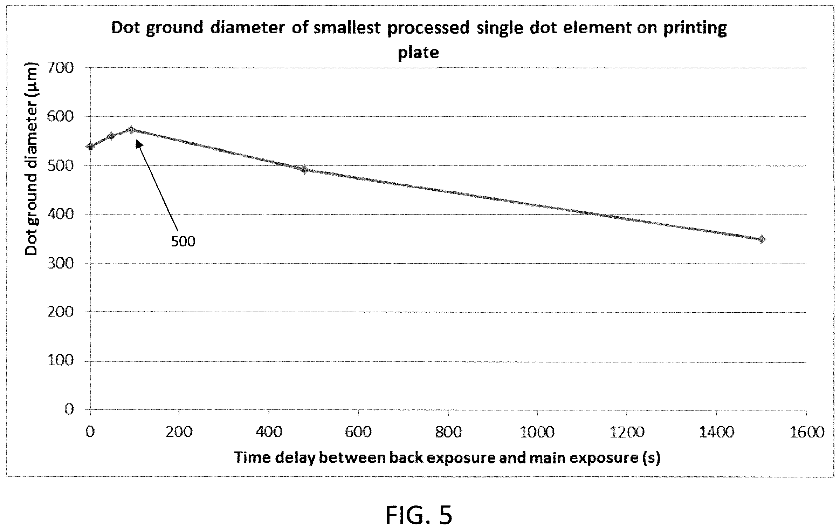

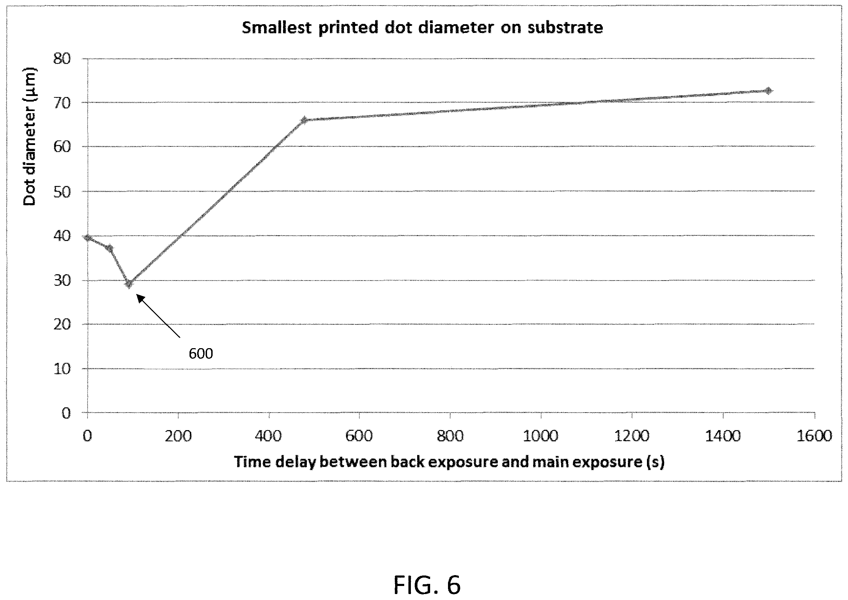

Results of exemplary time delays for exemplary single element structure numbers 64 and 144 are shown in FIGS. 4-6. As shown in FIG. 5, a plot of the ground diameter of the smallest processed single dot element versus the time delay between back exposure and main exposure for any set of conditions yields a maximum 500 (i.e. 573.33 µm diameter at 92 seconds time delay, for the plot shown). Thus, the size of the base of the dot, and therefore the stability of the shape, can be optimized by optimizing the time delay between back exposure and main exposure. As shown in FIG. 6, a plot of the smallest printed dot on the substrate versus the time delay between back exposure and main exposure yields a minimum 600 (29 µm diameter at approximately 92 seconds time delay, for the plot shown). In general, the smallest printed dot size is desirable for highest resolution. In general, the smallest printed dot size with the largest dot ground diameter is optimal.

The optimized results shown in Figs. 4-6 above are specific to the particular printing plate system and other variables, such as speed, energy density, etc., for the example discussed herein. It should be understood to those of skill in the art that different printing plate systems, different speeds, different energy densities, and other variables may impact the optimum results achievable by the process described herein, and that similar graphs and optimums can be generated for any type of print system. In general, however, the delay time between the rear side exposure and the front side exposure may generally fall in the range between 10 and 200 seconds, more preferably a range between 2 and 100 seconds, and most preferably in a range of between 5 and 20 seconds. Minimizing the delay time minimizes overall processing time, and thus has an impact on overall throughput of a system. Accordingly, optimizing other conditions to minimize the time delay may also be beneficial.

Although the exemplary system shown in Fig. 1 illustrates the time delay schematically in a linear system, it should be understood that various exposure systems may be devised to provide the optimized time delay. In such exemplary systems, the UV light sources may comprise, for example and without limitation, LEDs, arrays of LEDs, fluorescent lights, such as fluorescent tubes, arc discharge lamps, or any other UV light source known in the art. Although described herein in connection with a UV system and referring to "UV light", it should be understood that the technology described herein is not specific to any particular type of radiation wavelength, visible or non-visible, and that the system may utilize any type of actinic radiation or other radiation that is functional to cause the photochemical reaction necessary to cure the type of plate used. Thus, the term "light source" as used herein refers to any type of actinic radiation source.

In one embodiment 700 depicted in FIG. 7, the printing plate 730 may be mounted on a transparent (e.g. glass) cylinder 760 rotating at a predetermined speed, with the main radiation source 710 disposed in a first location along the cylindrical path of rotation adjacent the external surface of the cylinder, and the back side radiation source 720 disposed in a second location along the cylindrical path of rotation adjacent the internal surface of the cylinder, with the respective locations of the sources spaced apart by the distance required to provide the time delay required at the speed of rotation. In such a system, the location of the light sources and/or the speed of rotation may be variable to provide different time delays. The photosensitive printing plate 730 may be a sleeve, such as a sleeve designed to fit over the transparent cylinder 760 of the system described above, or may be flat, but sufficiently flexible, to permit it to be disposed on and secured to the surface of the cylinder. It should be understood that the term "transparent" as used herein may refer to any material that permits a desired amount of radiation at the desired wavelength pass through the selected material. Thus, "transparent" as used herein, may refer to a material that is not visibly transparent or even translucent to the human eye.

In another exemplary embodiment 800, depicted in FIG. 8, each collective radiation source 810, 820 may emit a planar radiation field that is at least coextensive with both lateral dimensions of plate 830 (e.g. each collective radiation source 810, 820 may be configured to irradiate the entire plate surface all at once when activated, if configured to be activated in that manner), in which case the controller 850 may be configured to create a delay time by creating a time difference between turning on a portion of source 820 for exposing the back surface and turning on a portion of source 810 for exposing the main surface. The printing plate 830 may lay flat on a horizontal transparent (e.g. glass) plate 860 or may hang in a vertical orientation, such as from a hangar 170 as depicted in FIG. 1. Although depicted schematically as single continuous sources 810, 820 in FIG. 8, each source 810, 820 preferably comprises a plurality of individual subsources (not shown), such as fluorescent tubes or LED point sources that are individually controllable or controllable in subsets smaller than the overall irradiation field. The plurality of subsources may be coordinated and controlled to act as a single source, or individually activated in a desired pattern. For example, in a configuration comprising a plurality of stationary subsources and a stationary plate, the individual subsources may be independently controlled so that fewer than all of the individual subsources comprising source 810 are turned on at the same time and fewer than all of the individual subsources comprising source 820 are turned on the same time. The collective subsources may thus be controlled in any pattern that provides the desired time delay and avoids simultaneously irradiating the front and the back of the plate by subsources that are spatially aligned with one another relative to the same coordinates of the plate.

One exemplary control pattern may activate the radiation subsources in a sequence that causes relative motion between the radiation field and the plate, such as a movement that essentially mimics the same light patterns that would be provided by main and back linear sources attached to a carriage, but with the advantage of having no moving parts. The illumination pattern may be configured to illuminate multiple portions of the front and back simultaneously (e.g. such as in a pattern that mimics multiple carriages - one starting at one end of the plate, and one starting in the middle). The illumination pattern in such a configuration is not constrained to patterns that mimic one or more carriages, however, and may be implemented in any pattern that provides the desired time delay, overall exposure, and lack of simultaneous exposure from front and back for any particular cross sectional coordinate of the plate. The pattern may also comprise illuminating the entire back at once and then the entire front, either in a single exposure for each side, or in fractional exposures of the full required exposure for each side, with the desired time delay applied between each front and back exposure. Furthermore, although shown in a flat configuration, it should be understood that systems in which both the plate and the sources are stationary may also be arranged in a cylindrical configuration.

Optionally, the embodiment shown in FIG. 8 may also include optics (not shown). These optics may include lenses, mirrors and/or other optical hardware components to direct and/or confine the radiation emitted from the plurality of individual subsources (e.g. LEDs) to a specific area on printing plate 830. This configuration may produce a stronger contrast between the dark and illuminated areas on printing plate 830, thereby increasing accuracy of the exposure process.

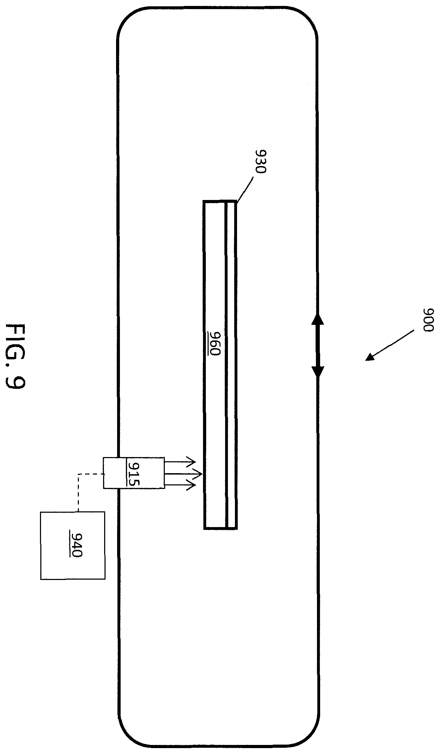

In yet another exemplary embodiment 900, a stationary plate 930 may be subjected to irradiation from a single linear source 915 that is configured to pass over both the front side and back side of the plate at a speed that provides the desired time delay, with a controller 940 that, for example, may turn the source on and off at the appropriate times or modulate the amount of radiation between a main exposure intensity and a back side exposure intensity, as needed. The plate may be disposed on a substrate 960 in a horizontal system, as depicted in FIG. 9, or the system may be oriented vertically, as described in other embodiments. It should be understood that the source may travel in either direction, so long as the controller first commences irradiation at the leading edge of the back side. The structure for moving the source may comprise, for example, a holder for the source mounted to a belt or chain that moves in a desired path. The source may move at a different speed (e.g. slower) when aligned over one side of the plate to cause an exposure than it does when it is traveling between the trailing edge of one side and the leading edge of the other side. In most embodiments, because the time delay is generally a fraction of the overall exposure time needed to expose the plate, this embodiment may be commercially practical only in processes in which the total exposure is spread over multiple passes.

It should be understood that the invention is not limited to any particular physical embodiment, and that the method of the invention of incorporating an optimized delay between back side and front side exposure may be performed in any system having any physical configuration.

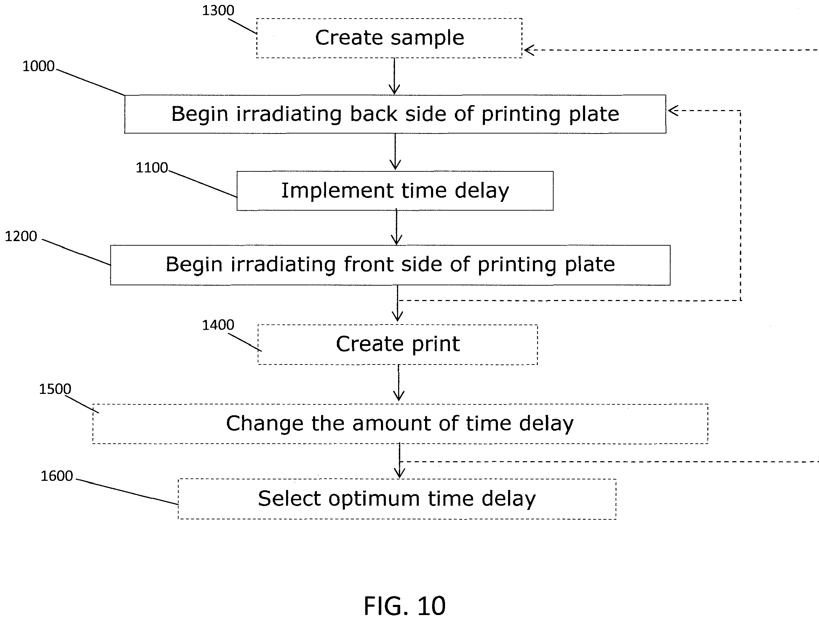

FIG. 10 illustrates an exemplary method for preparing a printing plate in accordance with the invention, including in step 1000, commencing irradiating the back side of the printing plate, implementing a defined time delay in step 1100, and then, immediately at the end of the time delay, commencing irradiating the front side of the printing plate in step 1200. In one embodiment, the exposure may be carried out using a multitude of consecutive exposure steps, in which each step contributes a fraction of the total energy dose required for complete curing of the plate, as is known in the art. In accordance with the invention, however, each exposure step includes the requisite time delay. Thus, as depicted in FIG. 10, in such an embodiment, each radiation step 1000 and 1200 may comprise only a fraction of the total radiation desired, and steps 1000, 1100, and 1200 may be repeated until the plate has been exposed to the total amount of radiation desired.

In a method for optimizing the time delay for a specific type of printing plate at a specific set of exposure conditions, also illustrated in FIG. 10, the method further comprises creating a first sample in step 1300, performing steps 1000, 1100, and 1200 on the sample at the specific set of exposure conditions, creating a print corresponding to the sample in step 1400, changing the time delay in step 1500, and then creating a new sample in step 1300 and performing steps 1000, 1100, and 1200 on the new sample. Steps, 1300, 1000, 1100, 1200, 1400, and 1500 may be repeated in sequence for a plurality of samples as many times as desired. Then, in step 1600, the optimum time delay is selected. In some embodiments, the time delay corresponding to the print having the smallest print dots may be optimal. In others, the optimum time delay may correspond to a minimum value for the smallest printed minimum dot diameter that coincides with a maximum value for the dot ground diameter for a range of time delay values.

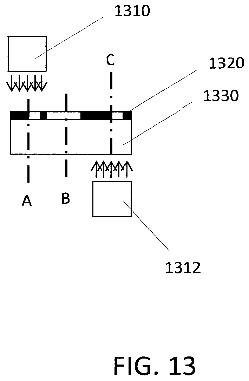

Notably, as illustrated in FIG. 1, front side radiation source 110 and back side radiation source 120 do not spatially overlap one another. Thus, in relative motion systems, in addition to distance D between the leading edge 122 of light source 120 and the leading edge 122 of light source 110 (which may be an adjustable distance), there is also preferably a distance (d) between the trailing edge 124 of light source 120 and leading edge 112 of light source 110. In other words, as illustrated in FIG. 13, at no time is any specific cross-sectional coordinate A, B, or C on the plate being exposed from both the front side and the back side simultaneously, and thus the apparatus as a whole is configured to prevent simultaneous irradiation of any specific cross sectional coordinate on the plate. As shown in FIG. 13, showing a snapshot of a particular portion of the plate during a specific moment in time during exposure, section A of plate 1330, which has ablated mask 1320 on a top layer thereof, is irradiated by top source 1310, section B is not irradiated by either source, and section C is irradiated by bottom source 1312, but there is no cross sectional coordinate corresponding to a line parallel to A, B, or C, that is being simultaneously irradiated by both sources. However, because the time delay is a fraction of the overall exposure time for the plate, both sources are actively providing radiation to some portion of the plate simultaneously over at least a portion of the exposure time in most systems for most plate sizes. By making distance D shown in FIG. 1 adjustable, the relative motion velocity between the plate and the sources can be varied within a certain range, without changing the time delay between back and front exposure, because within that range D can be adjusted to compensate for the change in relative velocity.

Such a configuration may be provided by a spatial configuration as depicted with respect to Fig. 1, by a configuration of the controller, or by a combination thereof. Thus, in a system that does not create the time delay using a spatial distance between the main and back side radiation sources in combination with relative movement, but rather by pulsing stationary sources relative to a stationary plate, such as is depicted in system 800, back side radiation source 820 (or one or more subsources) may spatially overlap with front side radiation source 810 (or one or more of subsources), but the controller is configured so that such overlapping sources never actively irradiate the plate at the same time.

Finally, while the time delay may be the same for each area of the plate, it should be understood that depending upon the configuration of the radiation sources, controller, and control scheme, one portion of the plate may be irradiated differently than another, if desired.

Although the invention is illustrated and described herein with reference to specific embodiments, the invention is not intended to be limited to the details shown. Rather, various modifications may be made in the details within the scope and range of equivalents of the claims and without departing from the invention.

## Claims

1. An apparatus (100, 800) for exposing a printing plate (130, 830), the printing plate comprising a photosensitive polymer (134) activated by exposure to radiation, the printing plate (130, 830) having a non-printing back side and a printing front side with a mask (132) for defining an image to be printed, the apparatus comprising:
- one or more radiation sources (110, 120, 810, 820) collectively arranged to expose the front side and the back side of the printing plate (130, 180) to radiation, and
- a holder (160, 860) configured to receive the printing plate (130, 830) in a position to receive incident radiation from the one or more radiation sources (110, 120, 810, 820), and
- a controller (140, 840) connected to the one or more radiation sources (110, 120, 810, 820), wherein the apparatus is configured to, for each specific coordinate corresponding to a cross-sectional portion of the printing plate (130, 830), first commence irradiating the non-printing back side of the printing plate, then automatically impose a defined time delay, and then immediately after the time delay elapses, commence irradiating the printing front side of the printing plate (130, 830), without exposing any specific coordinate to front side and back side irradiation simultaneously.

2. The apparatus (800) of claim 1, wherein the one or more radiation sources comprises a back side radiation source (820) and a front side radiation source (810), the back side radiation source (820) spatially overlapping the front side radiation source (810), and wherein the controller (840) is configured such that overlapping radiation sources of the back side radiation source (820) and the front side radiation source (810) do not irradiate the printing plate at the same time.

3. The apparatus (100, 800) of any one of the preceding claims, wherein the apparatus is configured to control the one or more radiation sources to illuminate the entire non-printing back side of the printing plate (130, 830) at once and then the entire printing front side of the printing plate.

4. The apparatus (100, 800) of any one of the preceding claims, wherein the time delay is in a range between about 10 and 200 seconds, more preferably in a range between about 2 and 100 seconds, and most preferably in a range of between about 5 and 20 seconds.

5. The apparatus (100, 800) of any one of the preceding claims, wherein the one or more radiation sources comprise a plurality of LED point sources (1212) configured to emit UV light, and wherein the controller is configured to individually control the plurality of LED point sources (1212) and/or to control the plurality of LED point sources (1212) in groups.

6. The apparatus (100, 800) of any one of the preceding claims, further comprising a substrate (160, 860) configured to receive the printing plate (130, 830) in a position to receive incident radiation from the one or more radiation sources, wherein the printing plate is stationary during irradiating the printing plate.

7. The apparatus of any one of claims 2 to 6, wherein the back side radiation source has a radiation field covering an area coextensive with a length and a width of the printing plate.

8. The apparatus of any one of claims 2 to 7, wherein the front side radiation source has a radiation field covering an area coextensive with a width of the printing plate.

9. The apparatus of any one of the preceding claims, wherein the irradiance at the back side exposure is only a fraction of the irradiance of the front side exposure.

10. A process for exposing a printing plate (130, 830) comprising a photosensitive polymer (134) activated by exposure to radiation, the printing plate having a non-printing back side and a printing front side with a mask (132) for defining an image to be printed, the method comprising:
- controlling one or more radiation sources (110, 120, 810, 820) collectively arranged to expose the front side and the back side of the printing plate (130, 830) to radiation to, for each specific coordinate corresponding to a cross-sectional portion of the printing plate, first commence irradiating the non-printing back side of the printing plate, then automatically impose a defined time delay, and then immediately after the time delay elapses, commence irradiating the printing front side of the printing plate, without exposing any specific coordinate to front side and back side irradiation simultaneously.

11. The method of claim 10, wherein the time delay is in a range between about 10 and 200 seconds, more preferably in a range between about 2 and 100 seconds, and most preferably in a range of between about 5 and 20 seconds.

12. The method of claim 10 or 11, wherein the one or more radiation sources comprises a back side radiation source (820) and a front side radiation source (810), the back side radiation source spatially overlapping the front side radiation source, and wherein the back side radiation source and the front side radiation source are controlled such that overlapping radiation sources of the back side radiation source and the front side radiation source do not irradiate the printing plate at the same time.

13. The method of any one of claims 10 to 12, wherein the printing plate is stationary.

## Patentansprüche

1. Eine Vorrichtung (100, 800) zum Belichten einer Druckplatte (130, 830), wobei die Druckplatte ein lichtempfindliches Polymer (134) umfasst, das durch Belichtung mit bzw. Aussetzung einer Strahlung aktiviert wird, wobei die Druckplatte (130, 830) eine nichtdruckende Rückseite und eine druckende Vorderseite mit einer Maske (132) zum Definieren eines zu druckenden Bildes aufweist, wobei die Vorrichtung Folgendes umfasst:
- eine oder mehrere Strahlungsquellen (110, 120, 810, 820), die gemeinsam so angeordnet sind, dass sie die Vorderseite und die Rückseite der Druckplatte (130, 180) einer Strahlung aussetzen, und
- einen Halter (160, 860), der so konfiguriert ist, dass er die Druckplatte (130, 830) in einer Position aufnimmt, in der sie einfallende Strahlung von der einen oder den mehreren Strahlungsquellen (110, 120, 810, 820) empfängt, und
- eine Steuerung (140, 840), die mit der einen oder den mehreren Strahlungsquellen (110, 120, 810, 820) verbunden ist, wobei die Vorrichtung so konfiguriert ist, dass sie für jede spezifische Koordinate, die einem Querschnittsabschnitt der Druckplatte (130, 830) entspricht, zunächst mit der Bestrahlung der nichtdruckenden Rückseite der Druckplatte beginnt, dann automatisch eine definierte Zeitverzögerung auferlegt bzw. einführt und dann unmittelbar nach Ablauf der Zeitverzögerung mit der Bestrahlung der druckenden Vorderseite der Druckplatte (130, 830) beginnt, ohne irgendeine spezifische Koordinate gleichzeitig einer Bestrahlung der Vorderseite und der Rückseite auszusetzen.

2. Die Vorrichtung (800) nach Anspruch 1, wobei die eine oder die mehreren Strahlungsquellen eine rückseitige Strahlungsquelle (820) und eine vorderseitige Strahlungsquelle (810) umfassen, wobei die rückseitige Strahlungsquelle (820) die vorderseitige Strahlungsquelle (810) räumlich überlappt, und wobei die Steuerung (840) so konfiguriert ist, dass überlappende Strahlungsquellen der rückseitigen Strahlungsquelle (820) und der vorderseitigen Strahlungsquelle (810) die Druckplatte nicht gleichzeitig bestrahlen.

3. Die Vorrichtung (100, 800) nach irgendeinem der vorstehenden Ansprüche, wobei die Vorrichtung so konfiguriert ist, dass sie die eine oder die mehreren Strahlungsquellen so steuert, dass sie die gesamte nichtdruckende Rückseite der Druckplatte (130, 830) auf einmal und dann die gesamte druckende Vorderseite der Druckplatte beleuchtet.

4. Die Vorrichtung (100, 800) nach irgendeinem der vorstehenden Ansprüche, wobei die Zeitverzögerung in einem Bereich zwischen etwa 10 und 200 Sekunden, bevorzugter in einem Bereich zwischen etwa 2 und 100 Sekunden und am meisten bevorzugt in einem Bereich zwischen etwa 5 und 20 Sekunden liegt.

5. Die Vorrichtung (100, 800) nach irgendeinem der vorstehenden Ansprüche, wobei die eine oder die mehreren Strahlungsquellen eine Vielzahl von LED-Punktquellen (1212) umfassen, die so konfiguriert sind, dass sie UV-Licht emittieren, und wobei die Steuerung so konfiguriert ist, dass sie die Vielzahl von LED-Punktquellen (1212) einzeln steuert und/oder die Vielzahl von LED-Punktquellen (1212) in Gruppen steuert.

6. Die Vorrichtung (100, 800) nach irgendeinem der vorstehenden Ansprüche, die ferner ein Substrat (160, 860) umfasst, das so konfiguriert ist, dass es die Druckplatte (130, 830) in einer Position aufnimmt, in der sie einfallende Strahlung von der einen oder den mehreren Strahlungsquellen empfängt, wobei die Druckplatte während der Bestrahlung der Druckplatte stationär ist.

7. Die Vorrichtung nach irgendeinem der Ansprüche von 2 bis 6, wobei die rückseitige Strahlungsquelle ein Strahlungsfeld aufweist, das einen Bereich abdeckt, der mit einer Länge und einer Breite der Druckplatte koextensiv ist.

8. Die Vorrichtung nach irgendeinem der Ansprüche von 2 bis 7, bei der die vorderseitige Strahlungsquelle ein Strahlungsfeld aufweist, das einen Bereich abdeckt, der mit der Breite der Druckplatte koextensiv ist.

9. Die Vorrichtung nach irgendeinem der vorstehenden Ansprüche, wobei die Bestrahlungsstärke bei der rückseitigen Belichtung nur einen Bruchteil der Bestrahlungsstärke der vorderseitigen Belichtung beträgt.

10. Ein Verfahren zum Belichten einer Druckplatte (130, 830), die ein lichtempfindliches Polymer (134) umfasst, das durch Belichtung mit bzw. Aussetzung einer Strahlung aktiviert wird, wobei die Druckplatte eine nichtdruckende Rückseite und eine druckende Vorderseite mit einer Maske (132) zum Definieren eines zu druckenden Bildes aufweist, wobei das Verfahren Folgendes umfasst:
- Steuern einer oder mehrerer Strahlungsquellen (110, 120, 810, 820), die kollektiv angeordnet sind, um die Vorderseite und die Rückseite der Druckplatte (130, 830) einer Strahlung auszusetzen, um für jede spezifische Koordinate, die einem Querschnittsabschnitt der Druckplatte entspricht, zunächst mit der Bestrahlung der nichtdruckenden Rückseite der Druckplatte zu beginnen, dann automatisch eine definierte Zeitverzögerung aufzuerlegen und dann unmittelbar nach Ablauf der Zeitverzögerung mit der Bestrahlung der druckenden Vorderseite der Druckplatte zu beginnen, ohne irgendeine spezifische Koordinate gleichzeitig einer Bestrahlung der Vorderseite und der Rückseite auszusetzen.

11. Das Verfahren nach Anspruch 10, wobei die Zeitverzögerung in einem Bereich zwischen etwa 10 und 200 Sekunden, bevorzugter in einem Bereich zwischen etwa 2 und 100 Sekunden und am meisten bevorzugt in einem Bereich zwischen etwa 5 und 20 Sekunden liegt.

12. Das Verfahren nach Anspruch 10 oder 11, wobei die eine oder die mehreren Strahlungsquellen eine rückseitige Strahlungsquelle (820) und eine vorderseitige Strahlungsquelle (810) umfassen, wobei die rückseitige Strahlungsquelle die vorderseitige Strahlungsquelle räumlich überlappt, und wobei die rückseitige Strahlungsquelle und die vorderseitige Strahlungsquelle so gesteuert werden, dass überlappende Strahlungsquellen der rückseitigen Strahlungsquelle und der vorderseitigen Strahlungsquelle die Druckplatte nicht gleichzeitig bestrahlen.

13. Das Verfahren nach irgendeinem der Ansprüche von 10 bis 12, wobei die Druckplatte stationär ist.

## Revendications

1. Un appareil (100, 800) pour exposer une plaque d'impression (130, 830), la plaque d'impression comprenant un polymère photosensible (134) activé par exposition à un rayonnement, la plaque d'impression (130, 830) présentant une face arrière de non impression et une face avant d'impression avec un masque (132) pour définir une image à imprimer, l'appareil comprenant :
- une ou plusieurs sources de rayonnement (110, 120, 810, 820) agencées collectivement pour exposer la face avant et la face arrière de la plaque d'impression (130, 180) à un rayonnement, et
- un dispositif de maintien (160, 860) configuré pour recevoir la plaque d'impression (130, 830) dans une position pour recevoir un rayonnement incident provenant de la ou des sources de rayonnement (110, 120, 810, 820), et
- un dispositif de commande (140, 840) connecté à la ou aux plusieurs sources de rayonnement (110, 120, 810, 820), sachant que l'appareil est configuré pour, pour chaque coordonnée spécifique correspondant à une portion de section transversale de la plaque d'impression (130, 830), commencer tout d'abord à irradier la face arrière de non impression de la plaque d'impression, puis imposer automatiquement une temporisation définie, et ensuite, immédiatement après que le délai se soit écoulé, commencer à irradier la face avant d'impression de la plaque d'impression (130, 830), sans exposer simultanément aucune coordonnée spécifique à une irradiation de la face avant et de la face arrière.

2. L'appareil (800) d'après la revendication 1, sachant que la ou les sources de rayonnement comprennent une source de rayonnement de face arrière (820) et une source de rayonnement de face avant (810), la source de rayonnement de face arrière (820) chevauchant spatialement la source de rayonnement de face avant (810), et sachant que le dispositif de commande (840) est configuré de manière que les sources de rayonnement chevauchantes de la source de rayonnement de face arrière (820) et de la source de rayonnement de face avant (810) n'irradient pas la plaque d'impression en même temps.

3. L'appareil (100, 800) d'après l'une quelconque des revendications précédentes, sachant que l'appareil est configuré pour commander la ou les sources de rayonnement afin d'éclairer la totalité de la face arrière de non impression de la plaque d'impression (130, 830) en une seule fois, puis la totalité de la face avant d'impression de la plaque d'impression.

4. L'appareil (100, 800) d'après l'une quelconque des revendications précédentes, sachant que la temporisation se situe dans une plage comprise entre environ 10 et 200 secondes, plus préférablement dans une plage comprise entre environ 2 et 100 secondes, et le plus préférablement dans une plage comprise entre environ 5 et 20 secondes.

5. L'appareil (100, 800) d'après l'une quelconque des revendications précédentes, sachant que la ou les sources de rayonnement comprennent une pluralité de sources ponctuelles de DEL (1212) configurées pour émettre de la lumière UV, et sachant que le dispositif de commande est configuré pour commander individuellement la pluralité de sources ponctuelles de DEL (1212) et/ou pour commander par groupes la pluralité de sources ponctuelles de DEL (1212).

6. L'appareil (100, 800) d'après l'une quelconque des revendications précédentes, comprenant en outre un substrat (160, 860) configuré pour recevoir la plaque d'impression (130, 830) dans une position pour recevoir un rayonnement incident provenant de la ou des sources de rayonnement, sachant que la plaque d'impression est stationnaire pendant l'irradiation de la plaque d'impression.

7. L'appareil d'après l'une quelconque des revendications de 2 à 6, sachant que la source de rayonnement de face arrière présente un champ de rayonnement couvrant une zone coextensive avec une longueur et une largeur de la plaque d'impression.

8. L'appareil d'après l'une quelconque des revendications de 2 à 7, sachant que la source de rayonnement de face avant présente un champ de rayonnement couvrant une zone coextensive avec une largeur de la plaque d'impression.

9. L'appareil d'après l'une quelconque des revendications précédentes, sachant que l'éclairement énergétique pendant *(at)* l'exposition de la face arrière n'est qu'une fraction de l'éclairement énergétique de l'exposition de la face avant.

10. Un procédé d'exposition d'une plaque d'impression (130, 830) comprenant un polymère photosensible (134) activé par exposition à un rayonnement, la plaque d'impression présentant une face arrière de non impression et une face avant d'impression avec un masque (132) pour définir une image à imprimer, le procédé comprenant le fait de :
- commander une ou plusieurs sources de rayonnement (110, 120, 810, 820) agencées collectivement pour exposer la face avant et la face arrière de la plaque d'impression (130, 830) à un rayonnement pour, pour chaque coordonnée spécifique correspondant à une portion de section transversale de la plaque d'impression, commencer d'abord à irradier la face arrière de non impression de la plaque d'impression, puis imposer automatiquement un délai défini, et ensuite, immédiatement après l'écoulement du délai, commencer à irradier la face avant d'impression de la plaque d'impression, sans exposer simultanément une coordonnée spécifique quelconque à une irradiation de la face avant et de la face arrière.

11. Le procédé d'après la revendication 10, sachant que la temporisation est dans une plage comprise entre environ 10 et 200 secondes, plus préférablement dans une plage comprise entre environ 2 et 100 secondes, et le plus préférablement dans une plage comprise entre environ 5 et 20 secondes.

12. Le procédé d'après la revendication 10 ou 11, sachant que la ou les sources de rayonnement comprennent une source de rayonnement de face arrière (820) et une source de rayonnement de face avant (810), la source de rayonnement de face arrière chevauchant spatialement la source de rayonnement de face avant, et sachant que la source de rayonnement de face arrière et la source de rayonnement de face avant sont commandées de manière que les sources de rayonnement chevauchantes de la source de rayonnement de face arrière et de la source de rayonnement de face avant n'irradient pas la plaque d'impression en même temps.

13. Le procédé d'après l'une quelconque des revendications de 10 à 12, sachant que la plaque d'impression est stationnaire.
